# EUROPEAN PATENT APPLICATION

(11) **EP 4 369 376 A1**
(43) Date of publication of application: **15.05.2024**
(21) Application number: 22181108.6
(22) Date of filing: 24.06.2022
(51) Int. Cl.: H01J 37/244, H01J 37/28

(54) **IMPROVED TRANSMISSION ELECTRON MICROSCOPY**

(71) Applicant: FEI Company, Hillsboro, OR 97124 (US)
(72) Inventor: SHÁNEL, Ondrej L., Hillsboro, 97124 (US); HLAVENKA, Petr, Hillsboro, 97124 (US); STRAKA, Branislav, Hillsboro, 97124 (US); UNCOVSKÝ, Marek, Hillsboro, 97124 (US)
(74) Representative: Boult Wade Tennant LLP

(57) **Abstract**

Scanning transmission electron microscope (sTEM) 200, having a sample plane 30, the sTEM comprising a primary electron beam source 15 arranged to provide a primary electron beam 20 to a sample located at the sample plane of the sTEM, and an sTEM detector 80, wherein the sample plane is located between the primary electron beam source and the sTEM detector. A first secondary electron (SE) detector 50 is located between the primary electron beam source and the sample plane of the sTEM. A second SE detector 220 is located between the sample plane and the sTEM detector. Signal acquisition circuitry configured to acquire simultaneously a first signal from the first SE detector, a second signal from the second SE detector, and a third signal from the sTEM detector. There is also a method for generating an image from the sTEM by merging depth information from the first and second SE detector signals with the sTEM detector signal data.

## Description

### Field of the Invention

The present invention relates to a scanning transmission electron microscope (STEM) and in particular, to a STEM that detects secondary electrons emitted from features within samples.

### Background of the Invention

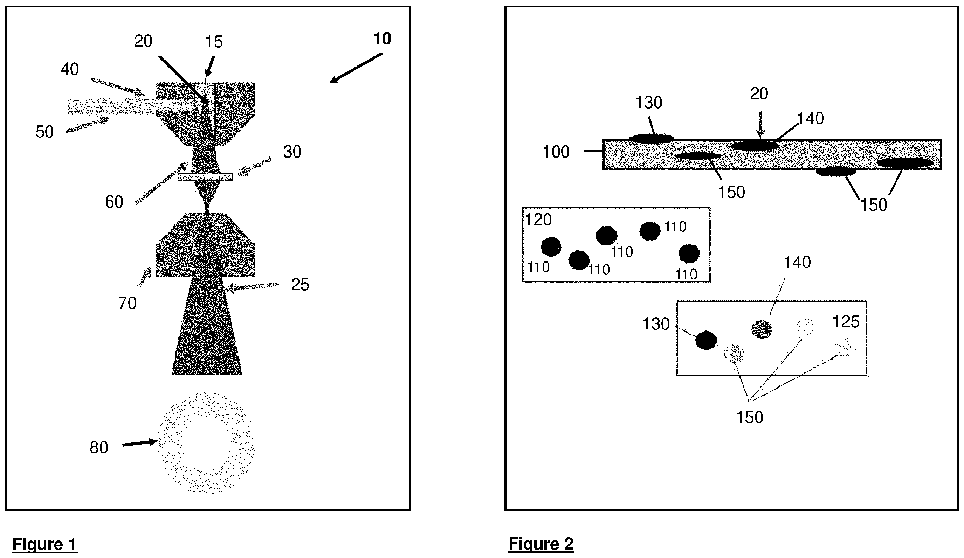

In existing scanning transmission electron microscopes (STEM) a beam of electrons is provided to a sample. Figure 1 shows a STEM 10 in an existing configuration.

An electron source 15 produces an electron beam 20 that is focused by a focusing element such as an upper electron objective pole piece 40. The electron beam 20 is directed towards a specimen or sample plane 30. A primary electron beam 25, having passed through the sample plane, is collected by a lower objective pole piece 70 and detected by STEM detector 80. The upper objective pole piece 40 steers the electron beam 20 across the sample plane 30, typically in a raster pattern, with the STEM detector 80 generating a signal at each position or continuously throughout a scan. These data are used to form a STEM image.

As well as transmission electrons forming the primary electron beam 25, secondary electrons 60 may also be scattered from features within the sample. These secondary electrons 60 can provide additional information about a sample and are detected by a secondary electron detector 50 located above the sample plane 30 (as shown in Figure 1) on the side of the sample plane adjacent to the electron source 15 and opposite the STEM detector 80. The secondary electron signals collected in this way may be used to visualise morphology of a particular sample. Therefore, the secondary electron detector 50 is used to obtain further data from features located on or just under the upper surface (as shown in figure 1) on the sample. For example, the secondary electron detector 50 is intended to provide additional data regarding features on the upper surface of thick or bulk samples. In this example STEM 10, data are either collected using the STEM detector 80 (e.g., for thin samples) or from the secondary electron detector 50 (e.g., to obtain information about features on the surface of thick or bulk samples).

Figure 2 illustrates schematically the sample 100 having individual features 110. The the electron beam 20 is directed at the sample from above, as shown in Figure 2. An example STEM image (collected from data acquired by the STEM detector 80) is shown as image 120 in Figure 2. An image formed from the data collected by the secondary electron detector 50 is shown as image 125. As can be seen from these two generated images, the same features can be identified in each image but having different intensities. Each sample feature 110 shown in the transmission STEM image 120 has similar signal intensity as they are formed from sample features having the same composition in this example. In contrast, the image 125 collected using the secondary electron detector 50 shows the same sample features 110 having different intensity values. This is because some of the sample features 110 generate more detected secondary electrons than others. For example, feature 130 is located at the surface of the sample 100 and so produces more secondary electrons (SE) that can be collected by the secondary electron detector 50 with full morphology information. Feature 140 is embedded below the surface of the sample 110 and so displays a lower signal than that generated by feature 130, as collected by the secondary electron detector 50. Features 150 within sample 100 are embedded further within the sample, including those on the opposite side of the sample to the secondary electron detector 50. These features exhibit much lower secondary electron activity, as detected by a secondary electron detector 50. Therefore, morphology information provided by the secondary electron image 125 is suppressed further for these features. As can be seen from this illustration, the attenuation is dependent on the depth of the feature 110 within the sample 100.

Using this type of existing STEM 10 provides little to no morphology information for features embedded deep within a sample (especially thick samples). Furthermore, this may only provide limited depth information for features, especially for those features having a composition with a low atomic number, which generate fewer secondary electrons.

Therefore, there is required a method and system that overcomes these problems.

### Summary of the Invention

A scanning transmission electron microscope (STEM) provides an electron beam to a sample. The electron beam is formed by an electron source and directed (e.g., by an electric field) towards the sample. The electron beam may have an energy of around 200 keV, for example. Two secondary electron (SE) detectors or sensors are provided above and below the sample. These detect secondary electrons scattered back towards a source of the electron beam and forwards from the sample and away from the source. Secondary electrons may have energies in the range of 2-10 keV. A STEM detector or sensor is also provided to detect a signal used to generate a STEM image. Scanning coils are also provided to steer the electron beam across the sample.

A sample may take the form of a thick sheet and a feature may be located in the bulk of the sample closer to one surface of the sheet than an opposite surface, for example. When the sample sheet is located at or around a sample plane of the STEM, one surface will face or be closer to one SE detector and the other surface of the sample will face or be closer to the other SE detector.

As the sample (located at or around the sample plane) is scanned by the electron beam, the STEM detector collects data. At the same time, the SE detectors detect any secondary electrons. The SE detectors may detect signals from particular features. For each detector, the signal at each point in the scan of the sample is also recorded. Therefore, the particular signal for each point in the sample from the three or more different detectors can be compared. However, the signal detected from the separate SE detectors may have a different amplitude values for the same feature. For example, features close to or at the surface of the sample sheet should generate a higher signal at the SE detector on that side of the sample than the SE detector on the other side of the sample. This may be due to the bulk of the sample attenuating (i.e., absorbing) secondary electrons as they pass through the sample. Therefore, comparing the signals collected by the SE detectors for the same point in the scan provides depth information (e.g., on the Z-axis of the STEM or in the direction of the electron beam). The depth information can be merged with the image generated by the STEM detector. If the material of the sample is known together with any attenuation properties of this material, then the accuracy of this depth information may be improved further. Data may be extracted or isolated from the detector data and provide information describing different layers with the sample. Therefore, virtual slicing of the sample may be achieved.

Against this background and in accordance with a first aspect there is provided a scanning transmission electron microscope, STEM, having a sample plane, the STEM comprising:
a primary electron beam source arranged to provide a primary electron beam to a sample located at the sample plane of the STEM;
a STEM detector, wherein the sample plane is located between the primary electron beam source and the STEM detector;
a first secondary electron, SE, detector located between the primary electron beam source and the sample plane of the STEM;
a second SE detector located between the sample plane and the STEM detector; and
signal acquisition circuitry configured to acquire simultaneously:
   a first signal from the first SE detector,
   a second signal from the second SE detector, and
   a third signal from the STEM detector. The STEM may be used to determine the three-dimensional localisation of features with a sample using a single scan (especially for thick samples where secondary electrons from features within the sample cannot be detected by the upper SE detector alone). Furthermore, having the second or lower SE detector allows data to be collected from secondary scattering of features located on opposing sides of a sample simultaneously.

Preferably, the STEM may further comprise data processing circuitry configured to:
receive the first, second and third signals and generate a first data set, a second data set and a third data set from the received first, second and third signals, respectively as the primary electron beam scans a sample.

Advantageously, the data processing circuitry may be further configured to receive position information of the primary electron beam corresponding to when the first, second and third signals are detected and incorporate the position information into the generated first data set, second data set and third data set. Therefore, the signals (e.g., amplitude or relative amplitude) can be correlated to an x-y, horizontal or sample plane position and with each other. The position information may be a particular coordinate in the sample plant or information that can be used to derive such coordinates.

Preferably, the first, second and third data sets may be image data. Other data types may be used. The data sets may include information used to generate image data, for example.

Preferably, the data processing circuitry may be further configured to:
generate depth information of one or more features identified within the third data set based on first and second signal data of the first and second data sets, having corresponding position information within the first and second data sets. The depth information may be z-axis data where the sample plane is in the x-y plane.

Preferably, the depth information may be perpendicular to the sample plane.

Optionally, the SE detectors may be annular detectors. Other detector types and shapes may be used.

Preferably, the STEM may further comprise upper (on the beam side of the sample) and lower (after the beam has passed through the sample plane) objective pole pieces configured to scan the primary electron beam source across the sample plane.

Optionally, the STEM detector may be dark field, DF, high-angle angle dark field, HAADF, DF, bright field, BF, or a pixelated detector. Other detector types may be used.

Optionally, the first SE detector, the second SE detector, and the STEM detector may coaxial with the electron beam provided by the primary electron beam source. Other configurations may be used.

In accordance with a second aspect, there is provided a method for generating an image from a scanning transmission electron microscope, STEM, having a primary electron beam source, a STEM detector, a first secondary electron, SE, detector and a second SE detector, the method comprising the steps of:
receiving a first signal from the first SE detector, a second signal from the second SE detector and a third signal from the STEM detector, wherein the first, second and third signals are detected simultaneously as the primary electron beam scans a sample;
receiving position information of the primary electron beam corresponding to when the first, second and third signals are detected;
generating a first image data set, a second image data set and a third image data set from the received first, second and third signals, respectively as the primary electron beam scans a sample and incorporate the position information into the first data set, the second data set and the third data set;
generating depth information perpendicular to the sample plane for one or more features identified within the third image data set based on first and second signal data of the first and second image data sets, having corresponding position information within the first and second data sets; and
merging the depth information with the third image data set to generate an output image.

Preferably, the method may further comprise the step of merging the first and second image data sets with the output image to generate a merged output image.

Optionally, the step of generating depth information for the one or more features may further comprise comparing the relative intensities of the first and second signal data having the corresponding position information of the one or more features. This can provide qualitative or quantitative depth information depending on how well the properties of the sample, beam and detectors are known.

Optionally, the step of generating the first image data set, the second image data set and the third image data set may further comprise normalising the first, second and/or third image data sets. This can help adjust or compensate for detector sensitivity differences, etc.

Advantageously, the step of generating the first image data set and the second image data set may further comprise estimating a signal noise floor of the first and second signals.

Preferably, the position information may be parallel to the sample plane.

The methods described above may be implemented as a computer program comprising program instructions to operate a computer. The computer program may be stored on a computer-readable medium.

The computer system may include a processor or processors (e.g. local, virtual or cloud-based) such as a Central Processing unit (CPU), and/or a single or a collection of Graphics Processing Units (GPUs). The processor may execute logic in the form of a software program. The computer system may include a memory including volatile and nonvolatile storage medium. A computer-readable medium may be included to store the logic or program instructions. The different parts of the system may be connected using a network (e.g. wireless networks and wired networks). The computer system may include one or more interfaces. The computer system may contain a suitable operating system such as UNIX, Windows (RTM) or Linux, for example.

It should be noted that any feature described above may be used with any aspect or embodiment of the invention.

### Brief description of the Figures

The present invention may be put into practice in a number of ways and embodiments will now be described by way of example only and with reference to the accompanying drawings, in which:
Fig. 1 shows a schematic diagram of a prior art scanning transmission electron microscope (STEM);
Fig. 2 shows a schematic diagram of a sample and images collected by the STEM of Figure 1;
Fig. 3 shows schematic diagram of a STEM according to one example embodiment;
Fig. 4 shows a schematic diagram of a sample and example images collected by the STEM of Figure 3;
Fig. 5 shows a flowchart of an example method for generating a STEM image from data collected by the STEM of figure 3;
Fig. 6 shows a schematic diagram of electrons interacting with features within a sample and example resultant images of those features collected by the STEM of Figure 3;
Fig. 7 shows a schematic diagram of the same sample as Fig. 5 together with signal intensities collected by the STEM of Figure 3 used to generate the images of Figure 5;
Fig. 8 shows a schematic diagram of signals and images generated by different detectors within the STEM of Figure 3; and
Fig. 9 shows a secondary electron detector used within the STEMs of Figures 1 and 3.

It should be noted that the figures are illustrated for simplicity and are not necessarily drawn to scale. Like features are provided with the same reference numerals.

### Detailed description of the preferred embodiments

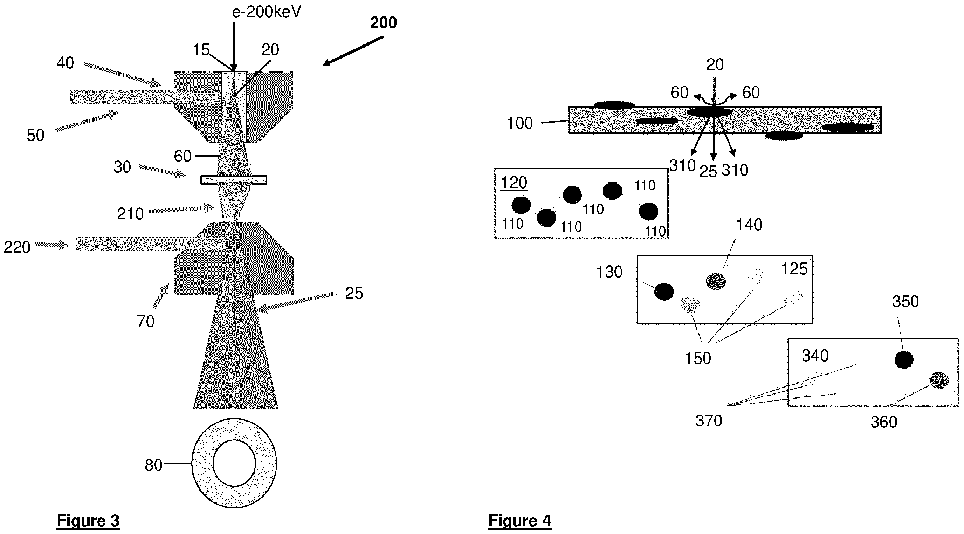

Figure 3 shows a schematic diagram of an example implementation of a scanning transmission electron microscope (STEM) 200 that provides additional information and data about a sample. In particular, the STEM 200 provides three-dimensional information about feature embedded within the sample. Component features that are similar to those described with reference the STEM 10 of Figure 1 have the same reference numerals. As with the STEM 10 described with reference to Figure 1, the STEM 200 shown in Figure 3 has an electron source 15 producing an electron beam 20 focused by an upper objective pole piece 40. In this example implementation, a primary electron beam 20 has an energy of at or around 200 keV. However, this may be varied, or other energy used. The STEM 200 also has a STEM detector 80. This may be of any suitable type (for example, the STEM detector may be annular and/or may be a high-angle annular dark-field (HAADF) detector.)

Other STEM detectors may be used. These may include pixelated detectors such as the Ceta-D, Falcon 4i, and Electron Microscope Pixel Array Detector (EMPAD) Cameras from ThermoFisher Scientific.

Secondary electrons (SE) 60 scattered back towards the electron source 15 are detected by an upper secondary electron detector 50. However, secondary electrons 210 that are scattered in the same direction as the primary electron beam 20 (i.e., in the direction towards the STEM detector 80) are detected by a second or lower scattering electron detector 220.

Circuitry within the STEM 200 controls the electron source 15, the steering of the electron beam 20 by the upper objective pole piece 40 across the sample plane 30. At the same time the circuitry (not shown in this figure) collects data from the STEM detector 80, the first or upper scattering electron detector 50 and the second or lower secondary electron detector 220.

The signals that are detected are stored together with or associated with the particular position at the sample plane 30 that were illuminated at that time. Therefore, the image data can be generated for each of these at least three detectors and the image data can be compared between them. These data may be stored within the STEM 200 or elsewhere (e.g., within a computer system that is not shown in this figure).

Figure 4 shows schematically how these image data may appear for a particular example sample 100 having features 110. The incident electron beam 20 generates secondary electrons 60 that are scattered from features within the sample in different directions. Electrons are transmitted through the sample as a bright field (BF) or primary beam 25 as well as dark field (DF) 310 electrons.

The images of Figure 4 may be compared with the images shown in Figure 2 obtained with the STEM 10, which does not have a second secondary electron detector below the sample plane 30. The image generated from STEM data collected by the STEM detector 80 (image 120) and the image 125 obtained from data collected by the upper or first secondary electron detector 50, are therefore the same as the example images (120, 125) generated using the STEM 10 of figure 1 (both use the same example sample). However, Figure 4 shows a further image generated from data obtained by the second or lower secondary electron detector 220. This image 340 has features 350, 360, 370 that also correspond with some of the features 110 on the sample 100. However, the intensity of the features shown in this figure 340 are different to those intensities shown by the image 125 generated by data collected by the secondary electron detector 50. Whereas the image features 130 and 140 show a high image intensity on image 125, corresponding features 370 in image 340 have a lower or no image intensity. This is because these features are located at or just below the top surface of the sample. Therefore, secondary electrons passing in the direction towards the electron source 15 are attenuated lightly because they are passing through less bulk material of the sample 100. Any secondary electrons that come from these features passing through the bulk of the sample 100 away from the electron source 15 will be attenuated more strongly and so their intensity as shown in image 340 will be much lower. In contrast, image features 350 and 360 shown in image 340 have much higher intensity as they are located on the bottom surface of the sample 100 and collected by the second secondary electron detector below the sample plane 30 and so are only lightly attenuated by any sample material.

Therefore, further information regarding the depth of particular sample features 110 may be obtained, as well morphology information that would otherwise not be available in the existing STEM 10 with only a single secondary electron detector 50 located above the sample plane 30. Furthermore, directly comparing data collected by all three detectors of the STEM 200 can yield additional spatial and morphological information about a sample.

Feature 130 on image 125 (the first SE detector 50 image) shown in figure 4 is visible (with the highest amplitude) as this feature is located at the upper surface (closest to the first SE detector 50). Therefore, the signal from this feature (SE signal) provides full information about the morphology or structure of this feature.

Feature 140 on image 125 shown in figure 4 (the first SE detector 50 image) is visible but has a lower amplitude or contrast because this feature is located at a depth from the surface Z, where Z < Lₑ (SE escape depth). Part of the morphology information provided by this signal is suppressed. The signals from the first SE detector 50 obtained from features 150 are further attenuated as these features are located deeper within the bulk sample (i.e., up to and including where Z > Lₑ).

Image 340 of figure 4 shows an inverse relationship for the same features as this image 340 is generated from data collected from the second SE detector 220. Therefore, feature 350 located on the bottom or lower surface of the bulk sample displays full morphology information in this SE-generated image 340 but features 370 contain little or no morphology information (Z > Lₑ).

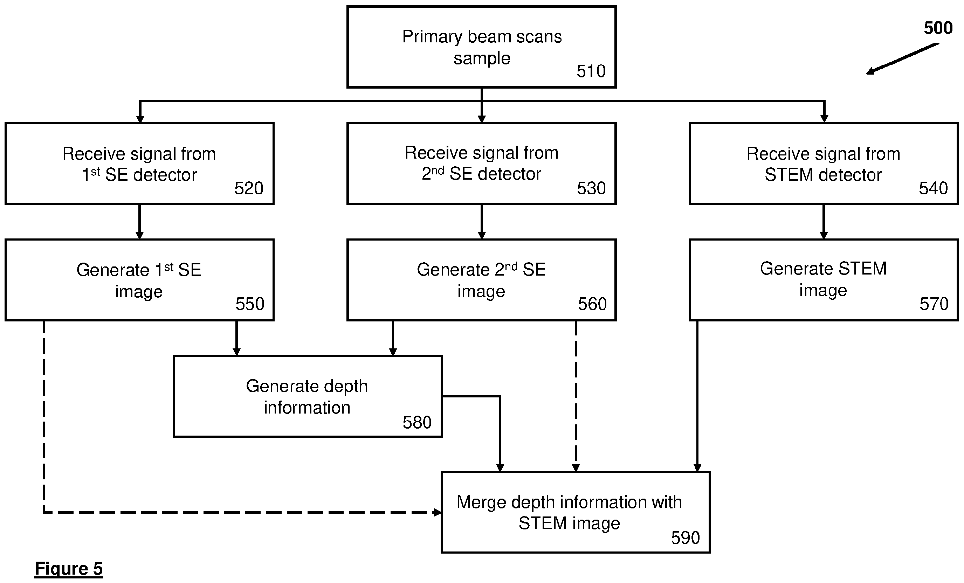

The STEM 200 may be operated in a number of ways to gain data about a particular sample. Figure 5 shows a flowchart such an example method 500 (e.g., a computer implemented method) of using these collected data to generate a STEM image with additional information. The method 500 commences once a sample has been placed at the sample plane 30 of the STEM 200. At step 510, the primary beam 20 scans the sample by using the upper objective pole piece 40 (e.g., by applying a suitable varying electric field to the beam path 20). As shown at steps 520, 530 and 540, simultaneous signals are received at processing circuitry (not shown) from the first SE detector 50, the second SE detector 220, and the STEM detector 80, respectively. These signals are received at each point of the sample scan and this particular position (e.g., pre-calibrated positions) is also recorded and stored as the primary beam scans the sample. Therefore, position and amplitude information can be correlated during subsequent processing. Furthermore, the beam energy may be altered depending on sample type and sample thickness.

Image data are generated from the received signals at steps 550 (from the first SE detector 50), at step 560 (from the second SE detector 220), and at step 570 (from the STEM detector 80). The STEM image corresponds to image 120 of Figure 4, the first SE image corresponds to image 125, as shown in Figure 4. The second SE image corresponds to image 340 shown in Figure 4.

Depth information is generated at step 580 using the first SE image and the second SE image. This depth information may be generated from intensity values at particular points in the image but may also take into account other parameters such as the properties of the particular sample and/or features within the sample. This may include attenuation coefficients of the bulk sample and/or scattering efficiencies or cross sections for particular features. The calculation of depth information may also use beam energy and pre-stored calibration data.

Even without these additional data, depth information may be discerned. At step 590, the depth information for each particular point in a scan is merged with the STEM image 120. These merged data are provided as an output image and the depth information may be displayed using any suitable technique such as colouring, contrast, brightness or highlighting, for example.

The STEM 200 may be calibrated for depth information. For example, one or more test samples may be used for calibration (e.g., with known bulk and feature compositions and with features placed at known depths in the sample). The incident electron beam energy may be varied to generate a plurality of images and/or data from each detector. The resultant STEM / SE images or data can be analysed to determine when secondary electrons are no longer detected from features at particular depths in the test samples. Therefore, when a sample having similar properties to a test sample is investigated by the STEM 200, then the depth in the bulk sample of particular features found in the images may be determined (e.g., by comparing amplitude data from test samples, with amplitude data of calibration samples). Therefore, virtual sectioning of a sample may be achieved (i.e., the ability to obtain image and composition information at different layers of a bulk sample). This also enhances resolution and contrast and provides three-dimensional sample information. The signal noise floor may also be estimated for each detector in advance.

Background removal techniques may be used instead of or as well as signal noise floor compensation. Examples of suitable background removal techniques include:
Histogram shape-based methods, where, for example, the peaks, valleys and curvatures of the smoothed histogram are analysed. These methods may make certain assumptions about the image intensity probability distribution (i.e., the shape of the histogram);
Clustering-based methods, where grey-level samples are clustered in two parts as background and foreground,
Entropy-based methods result in algorithms that use the entropy of the foreground and background regions, the cross-entropy between the original and binarized image, etc.;
Object Attribute-based methods search a measure of similarity between the grey-level and binarized images, such as fuzzy shape similarity, edge coincidence, etc.;
Spatial methods use higher-order probability distribution and/or correlation between pixels.

The data used to generate the first, second and/or third image data sets may also be normalised. This can help adjust or compensate for detector sensitivity and experimental variations.

The depth of sample features within the sample may be determined from the simultaneously collected data (from the STEM detector 80, the first SE detector 50 and the second SE detector 220). The z-coordinate (i.e., depth) information may be determined by analysing differences between signals collected from each detector. Therefore, an improved three-dimensional description of the sample structure can be determined. Morphology can also be determined simultaneously from the opposite (i.e., top and bottom) surfaces of a sample (e.g., lamelas).

The method may be implemented as a computer implemented method with the data being received by a separate processor or computer. Alternatively, the STEM 200 may include processing circuitry to carry out the method steps. Results may be saved to a storage device (e.g., hard drive), stored remotely and/or displayed on a display screen attached to the STEM 200 or computer. The storage device may also store calibration data for different sample types.

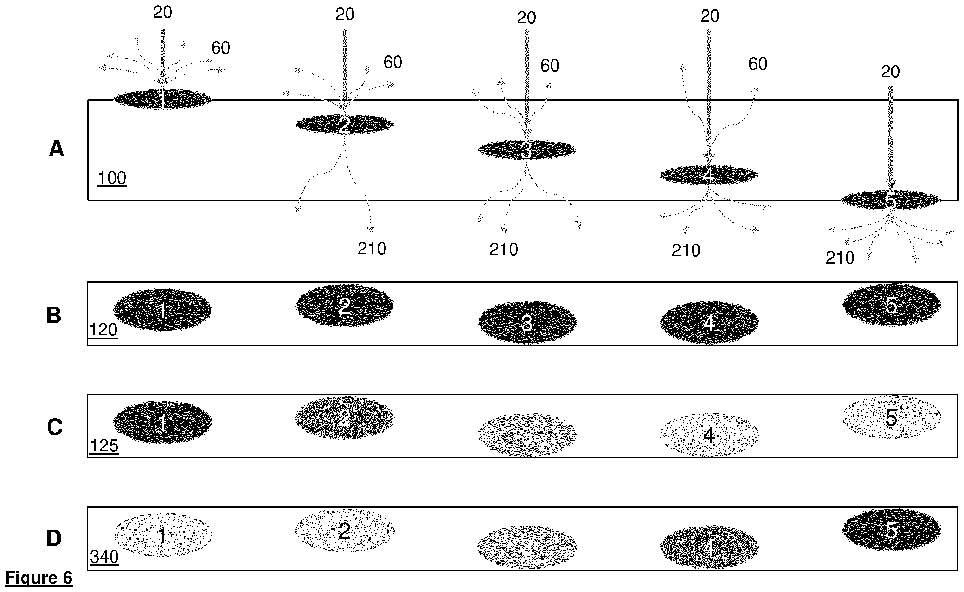

Figure 6 shows schematically how features 110 of a sample 100 may interact with the incident electron beam 20 and how the first and second SE detectors 50, 220 and the STEM detector 80 generate data forming the separate images 125, 140 and 120, respectively.

Cross-section A illustrates schematically the sample 100 with sample features 110 illustrated numerically as 1, 2, 3, 4, and 5. The incident electron beam 20 is shown interacting with each of these sample features. Secondary electrons 60 are shown (schematically) being scattered back towards the incident electron beam 20 and the number and density of these arrows (curved arrows) indicates the intensity of these secondary electrons 60, as detected by the first SE detector 50.

As the sample feature 1 is located on the surface of the sample 100 in this example, then more secondary electrons are detected by the first SE detector 50 than by the second SE detector 220, as little or no attenuation occurs through any bulk of the sample 100. In contrast, sample feature 5 is located on the opposite surface of the sample 100 and in this example, the bulk material of the sample 100 fully attenuates all secondary electrons and so are none are detected by the first or upper SE detector 50.

Secondary electrons that are scattered by sample features and detected by the second SE detector 220 (located below the sample plane 30 and on the side having the STEM detector) are also illustrated in cross-section A of Figure 6. These secondary electrons 210 that are detected by the second SE detector 220 are also shown as curved arrows in this figure with their number and density indicating the amplitude or signal level recorded by the second SE detector 220.

In this example, sample feature 5 shows the greatest intensity of these secondary electrons 210, as detected by the second SE detector 220. Sample feature 1 has no secondary electrons detected by the second SE detector 220 as they are attenuated or scattered away by the bulk material of sample 100. Sample features 2, 3, and 4 show intermediate signal levels depending on their location within the sample 100.

It should be noted that secondary electrons may be emitted in all directions but the arrows indicate only those secondary electrons that are detected by the two SE detectors 50, 220.

Image 120 (B) illustrates an example top view STEM image obtained from the same sample 100. Again, the same sample features are identified by numerals 1-5. As the primary electron beam 25 passing through the sample plane 30 is of much higher intensity (10 to 100 times) than the secondary electrons scattered off each sample feature then little or no attenuation is apparent in the STEM image 120. In this example, the properties of each sample feature 1-5 are similar and these sample features have the same contrast and properties. Therefore, the STEM image 120 contains no morphology or depth information for this particular example sample 100.

Example image 125 (C) illustrates image data generated from signals captured by the first or upper SE detector 50. The intensity of the signals corresponds with the amplitude of secondary electrons captured from secondary electrons 60 scattered back towards the electron source 15. Sample features closer to the top surface (as shown in this figure) have higher contrast and signal levels (in image 125 (C)) than sample features located deeper within the bulk of the sample 100. Sample 1 has the highest signal in this image and sample feature 5 generates little or no signal at all.

In contrast, example image 340 (D) illustrates schematically image data generated from signals collected by the second or lower SE detector 220. Sample features located closer to the bottom surface of the sample 100 have higher contrast signals than those sample features located towards or at the top surface of the sample 100.

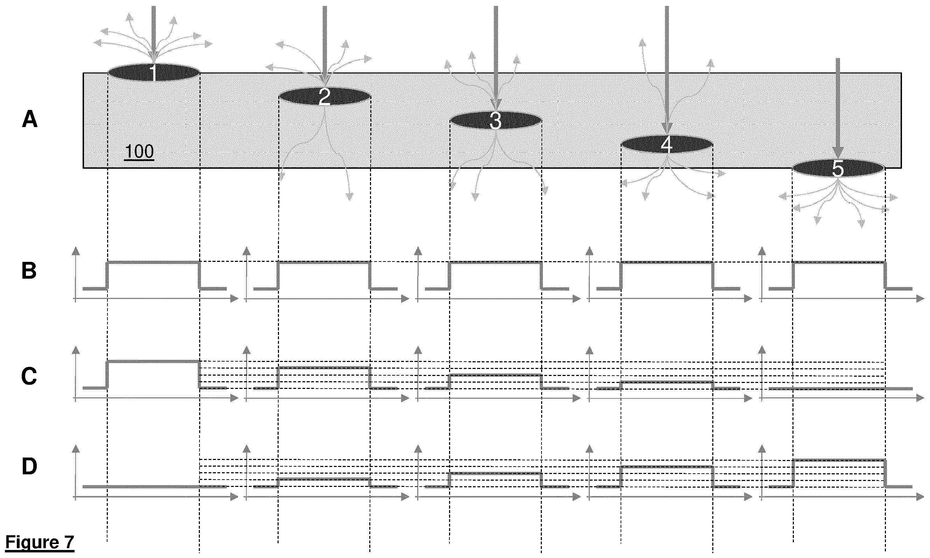

Figure 7 illustrates a representation of data collected by each of the three detectors, but in graphical form. The cross-sectional or side view of sample 100 is shown as row A. Row B shows a graph of signal intensity across an axis (left to right in this figure) as the scan moves in this direction with each point illuminated or exposed to the electron beam 20. The signal obtained by the first SE detector 50 is shown as row C with the same points on a vertical axis being linked by dotted lines to show that the data are aligned with sample position. Similarly, row D illustrates example data collected from the same sample 100 by the second SE detector 220.

Therefore, Figure 7 shows how at least one row of image data are collected and corresponds with the images (120, 125, 340) shown in Figure 6.

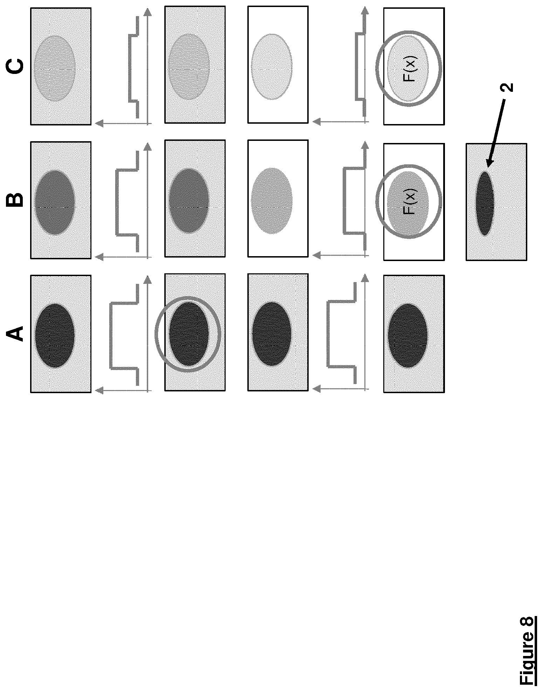

Figure 8 shows some additional processing that may be applied to account for system noise and other contributors to output errors. This figure shows schematically the processing of a particular feature or region of interest. Column A shows data acquired by the STEM detector 80. Column B shows data and image outputs shown for the same feature with data acquired by the first SE detector 50. Column C shows data and image outputs derived from data collected by the second or lower SE detector 220.

The graph on the second row of this figure corresponds with the signal acquired by the different detectors. The particular feature that is being illustrated in Figure 8 corresponds with feature 2 (shown in side view in this figure) from cross-section A in Figure 7. As with the previous methods, each image and data signals are collected simultaneously when the same point or location is exposed to the electron beam.

Each detector (and in particular the SE detectors) may be characterised before samples are investigated. From this detector characterisation process, detector noise (and/or a noise floor) may be determined. The signals from each detector (second row in Figure 8) are processed by applying a function to compensate for anomalies found during detector characterisation. These anomalies (and any determined function, normalisation function or calibration function) may be stored before processing for each sample. The sixth row of Figure 8 illustrates a function applied to the signals, which can change the contrast and intensity values of the resultant images. For example, signal intensity ratios may be applied to the signals. Such a mapping may be achieved across different points in a scan where, for example, these data can then be used to create depth profile information for particular features with greater accuracy. The function may change the contrast and intensity values of the resultant images in different ways. For example, if the material is known, then the function could account for the amount or percentage of secondary electrons that would be expected to pass through corresponding thicknesses of the sample (this would have an additional benefit of allowing the function to determine a thickness of the feature). Another example could be the function using a known thickness of the sample and the relative intensities found in images B and C, to determine an expected depth in the sample for the location of the feature. The function may also take into account the beam strength and the expected emission rate of secondary electrons for a particular feature material.

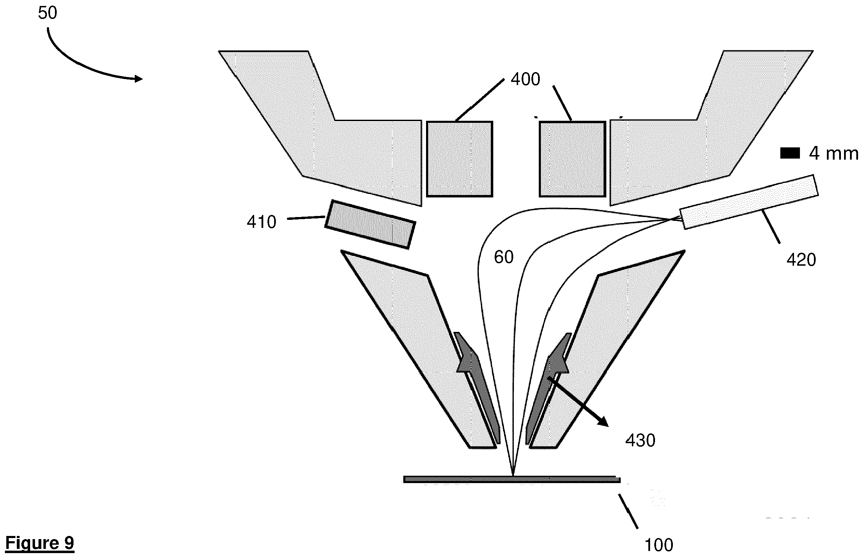

Figure 9 shows a schematic diagram of a SE detector that may be used for either or both of the first and second SE detectors 50, 220. This SE detector takes the form of an Elastar column but other SE detectors may be use (for example a Nicol column). The sample 100 emits secondary electrons 60. In the configuration shown in figure 9, the SE detector is the first SE detector 50 with the secondary electrons 60 scattered back towards the electron source 15. An identical but inverted detector may be used as the second SE detector 220.

A mirror 400 provides an electric field (e.g., -15V) to reflect the secondary electrons. Push electrode 410 (e.g., -100V) steer the secondary electrons 60 towards a scintillator 420. A bias tube applies a bias (e.g., +50V) to the secondary electrons 60.

As will be appreciated by the skilled person, details of the above embodiment may be varied without departing from the scope of the present invention, as defined by the appended claims.

For example, different detector types may be used. The SE detectors may also be annular.

Many combinations, modifications, or alterations to the features of the above embodiments will be readily apparent to the skilled person and are intended to form part of the invention. Any of the features described specifically relating to one embodiment or example may be used in any other embodiment by making the appropriate changes.

## Claims

1. A scanning transmission electron microscope, STEM, having a sample plane, the STEM comprising:
a primary electron beam source arranged to provide a primary electron beam to a sample located at the sample plane of the STEM;
a STEM detector, wherein the sample plane is located between the primary electron beam source and the STEM detector;
a first secondary electron, SE, detector located between the primary electron beam source and the sample plane of the STEM;
a second SE detector located between the sample plane and the STEM detector; and
signal acquisition circuitry configured to acquire simultaneously:
a first signal from the first SE detector,
a second signal from the second SE detector, and
a third signal from the STEM detector.

2. The STEM of claim 1 further comprising data processing circuitry configured to:
receive the first, second and third signals and generate a first data set, a second data set and a third data set from the received first, second and third signals, respectively as the primary electron beam scans a sample.

3. The STEM of claim 2, wherein the data processing circuitry is further configured to receive position information of the primary electron beam corresponding to when the first, second and third signals are detected and incorporate the position information into the generated first data set, second data set and third data set.

4. The STEM of claim 2, wherein the first, second and third data sets are image data.

5. The STEM according to any previous claim, wherein the data processing circuitry is further configured to:
generate depth information of one or more features identified within the third data set based on first and second signal data of the first and second data sets, having corresponding position information within the first and second data sets.

6. The STEM of claim 5, wherein the depth information is perpendicular to the sample plane.

7. The STEM according to any previous claim, wherein the SE detectors are annular detectors.

8. The STEM according to any previous claim further comprising upper and lower objective pole pieces configured to scan the primary electron beam source across the sample plane.

9. The STEM according to any previous claim, where the STEM detector is dark field, DF, high-angle angle dark field, HAADF, DF, bright field, BF, or a pixelated detector.

10. The STEM according to any previous claim, where the first SE detector, the second SE detector, and the STEM detector are coaxial with the electron beam provided by the primary electron beam source.

11. A method for generating an image from a scanning transmission electron microscope, STEM, having a primary electron beam source, a STEM detector, a first secondary electron, SE, detector and a second SE detector, the method comprising the steps of:
receiving a first signal from the first SE detector, a second signal from the second SE detector and a third signal from the STEM detector, wherein the first, second and third signals are detected simultaneously as the primary electron beam scans a sample;
receiving position information of the primary electron beam corresponding to when the first, second and third signals are detected;
generating a first image data set, a second image data set and a third image data set from the received first, second and third signals, respectively as the primary electron beam scans a sample and incorporate the position information into the first data set, the second data set and the third data set;
generating depth information perpendicular to the sample plane for one or more features identified within the third image data set based on first and second signal data of the first and second image data sets, having corresponding position information within the first and second data sets; and
merging the depth information with the third image data set to generate an output image.

12. The method of claim 11 further comprising the step of merging the first and second image data sets with the output image to generate a merged output image.

13. The method of claim 11 or claim 12, wherein the step of generating depth information for the one or more features further comprises comparing the relative intensities of the first and second signal data having the corresponding position information of the one or more features.

14. The method according to any of claims 11 to 13, wherein the step of generating the first image data set, the second image data set and the third image data set further comprises normalising the first, second and/or third image data sets.

15. The method according to any of claims 11 to 14, wherein the step of generating the first image data set and the second image data set further comprises estimating a signal noise floor of the first and second signals.

16. The method according to any of claim 11 to 15, wherein the position information is parallel to the sample plane.

17. A computer program comprising program instructions that, when executed on a computer cause the computer to perform the method of any of claims 11 to 16.

18. A computer-readable medium comprising instructions which, when executed by a computer, cause the computer to carry out the method of any of claims 11 to 16.
